# EUROPEAN PATENT SPECIFICATION

(11) **EP 2 727 136 B1**
(45) Date of publication and mention of the grant of the patent: **26.12.2018**
(21) Application number: 12804454.2
(22) Date of filing: 29.06.2012
(51) Int. Cl.: B81C 1/00

(54) **PROCESS FOR A SEALED MEMS DEVICE WITH A PORTION EXPOSED TO THE ENVIRONMENT**
VERFAHREN FÜR EINE VERSIEGELTE MEMS-VORRICHTUNG MIT EINEM HERAUSRAGENDEN TEIL
PROCÉDÉ DE FORMATION D'UN MICROSYSTÈME ÉLECTROMÉCANIQUE SCELLÉ AVEC UNE PARTIE EXPOSÉE À L'ENVIRONNEMENT

(30) Priority: 29.06.2011 US 201161502603 P; 28.06.2012 US 201213536896
(43) Date of publication of application: 07.05.2014
(73) Proprietor: InvenSense, Inc., Sunnyvale, California 94089 (US)
(72) Inventor: DANEMAN, Michael, J., Campbell, CA 95008 (US); LIM, Martin, San Mateo, CA 94402 (US); SEEGER, Joseph, Menlo Park, CA 94025 (US); TCHERTKOV, Igor, San Jose, CA 95130 (US); NASIRI, Steven, S., Saratoga, CA 95070 (US)
(74) Representative: Miller, James Lionel Woolverton
(86) International application number: PCT/US2012/045061
(87) International publication number: WO 2013/003784

(56) References cited:
- US-A- 6 159 761
- US-A1- 2005 170 656
- US-A1- 2005 255 677
- US-A1- 2006 163 679
- US-A1- 2008 053 236
- US-A1- 2008 053 236
- US-A1- 2008 061 428
- US-A1- 2008 211 043
- US-A1- 2008 277 258
- US-A1- 2009 317 302
- US-A1- 2010 133 546
- US-A1- 2011 147 909
- US-B1- 7 838 322
- US-B2- 6 788 840

## Description

### FIELD OF THE INVENTION

The present invention relates to Microelectromechanical Systems (MEMS) devices, and more particularly, to fabrication of MEMS devices with portions exposed to the outside environment.

### BACKGROUND

Many MEMS devices, specifically those measuring or modifying aspects of the environment outside of the device (e.g. pressure sensors, microphones, speakers, chemical sensors, biological sensors, optical sensors etc.) require a portion of the MEMS structure exposed to the outside environment. There is a strong need for a cost-effective and efficient fabrication process that implements and improves operation of such MEMS devices by fabricating devices with portions exposed to the outside environment. The present invention addresses such a need.

US 2008/0053236 discloses a capacitive pressure sensor and method for its fabrication. The sensor is fabricated from first and second wafers to have a mechanical capacitor comprising a fixed electrode and a moving electrode defined by a conductive plate. The sensor further has a diaphragm on a surface of the first wafer that is mechanically coupled but electrically insulated from the conductive plate. A conductive layer on the surface of the first wafer is spaced apart from the conductive plate to define the fixed electrode. The second wafer is bonded to the first wafer and carries interface circuitry for the sensor, including the conductive plate and the fixed electrode which are between the first and second wafers and electrically connected to the interface circuitry. At least an opening is present in the first wafer and its first conductive layer by which the diaphragm is released and exposed to an environment surrounding the sensor.

US 6159761 discloses a method of manufacturing a force sensor having an electrode which changes resistance or electrostatic capacitance in response to force. A first substrate of the three layer structure composed of a lower layer portion consisting of silicon, a middle layer portion consisting of SiO2 and an upper layer portion consisting of silicon is prepared. The lower surface of the lower layer portion is etched to form a diaphragm portion and a pedestal portion, and then a second substrate consisting of glass is joined to the portion therebelow. By the electrodes on the second substrate and the diaphragm portion, capacitance elements are formed. Grooves are dug by a dicing blade from the upper surface of the upper layer portion thereafter to downwardly dig the bottom portions of the grooves by etching until the upper surface of the lower layer portion is exposed. When the respective unit areas are cut off, there is obtained a structure in which a weight body is positioned at the central portion of the diaphragm portion and a pedestal is formed at the periphery thereof.

### SUMMARY OF THE INVENTION

A method and system for providing a MEMS device with a portion exposed to an outside environment are disclosed. In a first aspect, the method comprises bonding a handle wafer to a device wafer to form a MEMS substrate with a dielectric layer disposed between the handle and device wafers. The method includes lithographically defining at least one standoff on the device wafer and bonding the at least one standoff to an integrated circuit substrate to form a sealed cavity between the MEMS substrate and the integrated circuit substrate. The method includes etching at least one opening in the handle wafer to expose a portion of the dielectric layer, etching the exposed portion of the dielectric layer to expose a portion of the device wafer to the outside environment and partially etching the exposed portion of the device wafer to reduce thickness of the device wafer.

In a second aspect, the MEMS device comprises a CMOS substrate and a MEMS substrate bonded to the CMOS substrate. The MEMS substrate includes a handle substrate bonded to a device substrate with a dielectric layer disposed between the handle and device substrates. The MEMS device includes at least one opening in the handle substrate, the dielectric layer and partially in the device substrate, wherein the at least one opening exposes a portion of the device substrate to the outside environment.

### BRIEF DESCRIPTION OF THE DRAWINGS

The accompanying figures illustrate several embodiments of the invention and, together with the description, serve to explain the principles of the invention. One of ordinary skill in the art readily recognizes that the particular embodiments illustrated in the figures are merely exemplary, and are not intended to limit the scope of the present invention.
Figure 1 illustrates a starting material for a first MEMS device in accordance with an example.
Figure 2 illustrates the first MEMS device with a first etch of the handle wafer in accordance with an example.
Figure 3 illustrates the first MEMS device with a second etch of the dielectric layer in accordance with an example.
Figure 4a illustrates the first MEMS device with an optional third etch of the device wafer in accordance with an embodiment.
Figure 4b illustrates the first MEMS device where the etched opening is located over a stand-off frame, such that the dimensions of a flexible portion of the device wafer are defined by the location of the stand-off frame rather than the location and dimensions of the etched opening.
Figure 5 illustrates a MEMS device with a device wafer that comprises two layers of silicon in accordance with an embodiment.
Figure 6 illustrates a first wafer-level packaging process of the first MEMS device in accordance with an embodiment.
Figure 7 illustrates a second wafer-level packaging process of the first MEMS device in accordance with an embodiment.
Figure 8 illustrates the photoresist patterning deposition of the second wafer-level packaging process in accordance with an embodiment.
Figure 9 illustrates a plastic-molding packaging process of a MEMS device in accordance with an example.
Figure 10a illustrates a MEMS device in accordance with an example.
Figure 10b illustrates a second MEMS device in accordance with an example.
Figure 11 illustrates a top view of a cavity of a MEMS device in accordance with an example.
Figure 12 illustrates a cross-section view A-A' of the MEMS device of Figure 11 in accordance with an example.
Figure 13 illustrates a cross-section view of a MEMS device with a cavity exposed to the outside environment through a standoff layer side-channel in accordance with an example.
Figure 14 illustrates a top view and a cross-section view of a MEMS device with a side-channel defined by a cavity in the CMOS wafer in accordance with an example.
Figure 15 illustrates a MEMS device in accordance with an example.
Figure 16 illustrates a fabrication process of a MEMS device to create a CMOS wafer opening in accordance with an example.
Figure 17 illustrates a MEMS device in accordance with an example.
Figure 18 illustrates a fabrication process of thinning a portion of a device wafer prior to fusion bonding to a handle wafer of a MEMS device in accordance with an example.
Figure 19 illustrates a further fabrication process of a MEMS device that has been thinned and processed according to the fabrication process of Figure 18 in accordance with an embodiment.

### DETAILED DESCRIPTION

The present invention relates to Microelectromechanical Systems (MEMS) devices, and more particularly, to fabrication of MEMS devices with portions exposed to the outside environment. The following description is presented to enable one of ordinary skill in the art to make and use the invention and is provided in the context of a patent application and its requirements. Various modifications to the described embodiments and the generic principles and features described herein will be readily apparent to those skilled in the art. Thus, the present invention is not intended to be limited to the embodiments shown but is to be accorded the widest scope consistent with the principles and features described herein.

A CMOS-MEMS integrated process can be utilized to create hermetically sealed MEMS devices that are integrated with CMOS wafers/substrates through wafer
bonding. The resulting MEMS devices are sealed inside the resulting enclosure and do not have direct exposure to the environment. For some devices including but not limited to pressure sensors, optical MEMS, biological sensors, it is desirable for the MEMS structure to directly interface with the environment.

A method and system in accordance with the present invention provides a process for fabricating a MEMS device with a portion exposed to an outside environment. By bonding a MEMS substrate to an integrated circuit substrate and etching a portion of the MEMS substrate, the portion of the MEMS substrate is then exposed to the outside environment. The portion of the MEMS substrate that is exposed to the outside environment may be thinner than the remaining structural device layers of the MEMS substrate to enable the creation of a pressure sensor or related MEMS device that requires enhanced sensitivity. The integration of such pressure sensor or related MEMS devices with other MEMS devices including but not limited to motion sensors is also achieved by the fabrication process.

To describe the features of the present invention in more detail, refer now to the following description in conjunction with the accompanying Figures.

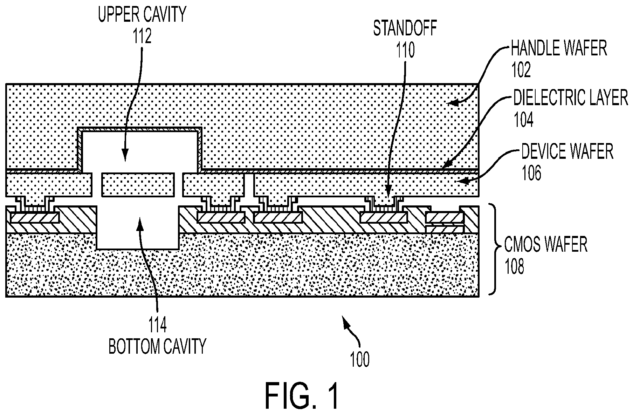

Figure 1 illustrates a starting material for a MEMS device 100 in accordance with an embodiment. The MEMS device 100 includes a MEMS substrate that comprises a handle wafer 102 and a device wafer 106 coupled to the handle wafer 102 via a dielectric layer 104. In one embodiment, the device wafer 106 is a pure silicon wafer. In one embodiment, the dielectric layer 104 is an oxide layer. The MEMS device 100 includes a CMOS wafer 108 coupled to the device wafer 106 of the MEMS substrate via at least one standoff 110. The MEMS device 100 includes an upper cavity 112 and a bottom cavity 114.

Thus, MEMS device 100 is a starting CMOS-MEMS bonded wafer that is created through a standard process. A top surface of the MEMS substrate is coated by a photoresist material and an opening is photolithographically defined over a region of the MEMS substrate that is to be exposed to the outside environment. In one embodiment, the starting wafer has a portion of the MEMS structural device layer thinned to a desired thickness prior to bonding with the CMOS wafer.

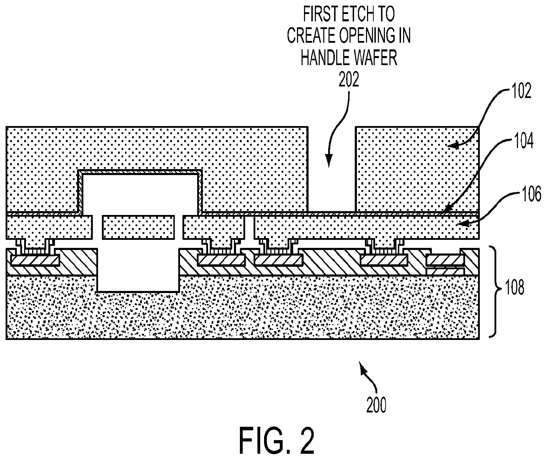

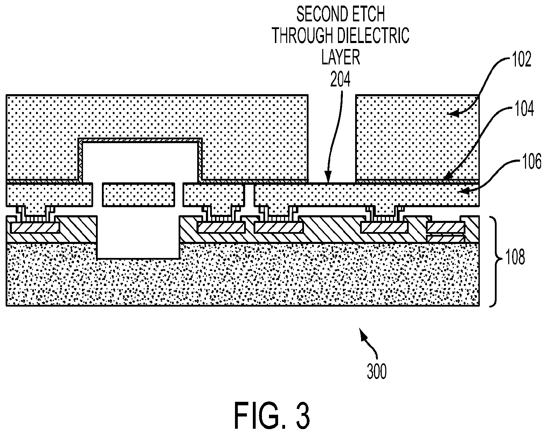

Figure 2 illustrates the MEMS device 200 with a first etch 202 of the handle wafer 102 in accordance with an embodiment. In one embodiment, the first etch 202 is a membrane DRIE etch through the handle wafer 102 that stops when it reaches a top surface of the dielectric layer 104 that is buried below the handle wafer 102, which creates an initial opening or cavity in the handle wafer 102. Figure 3 illustrates the MEMS device 300 with a second etch 204 of the handle wafer 102 in accordance with an embodiment. In one embodiment, the second etch 204 is a membrane DRIE etch through the dielectric layer 104 that stops when it reaches a top surface of the device wafer 106. At this point, the top surface of the device wafer 106 is now exposed to the outside environment.

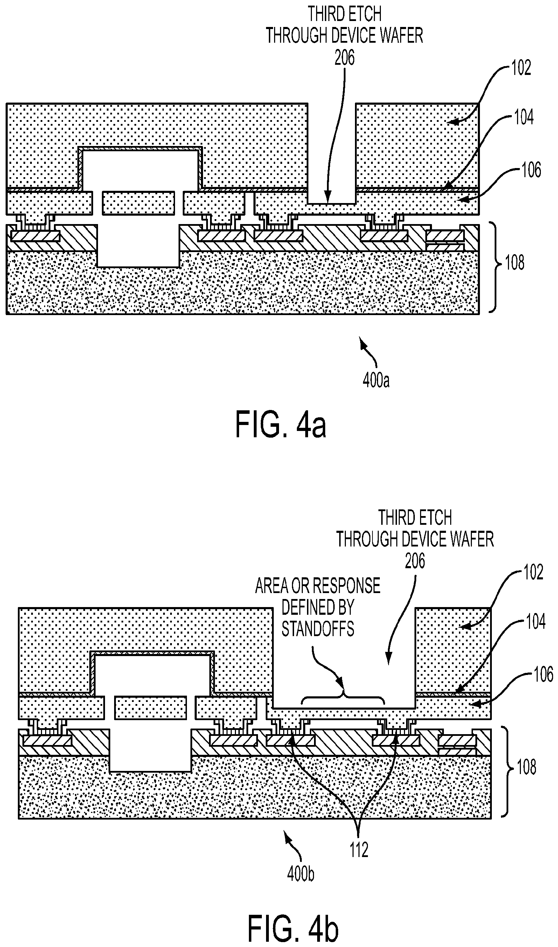

Figure 4a illustrates the MEMS device 400a with a third etch 206 of the handle wafer 102 in accordance with an embodiment of the invention. In one embodiment, the third etch 206 is a membrane DRIE etch through the device wafer 106 that stops when it reaches a desired membrane thickness. One of ordinary skill in the art readily recognizes that the desired membrane thickness can vary in accordance with differing needs and applications. Each of the first, second, and third etches 202-206 can be timed so as to stop the etch process at predetermined time periods and exacting thickness levels. Additionally, each of the first, second, and third etches 202-206 are selectively etched using a wet or dry etch.

Figure 4b is an embodiment where the lateral membrane dimensions are determined by a contiguous standoff frame, 112. The diameter of the membrane, 116, is determined by the inner dimensions of the standoff frame. This membrane size definition may have superior lateral dimensional control than membranes defined by the first, second, and, third etches patterned from the topside of handle wafer, 102

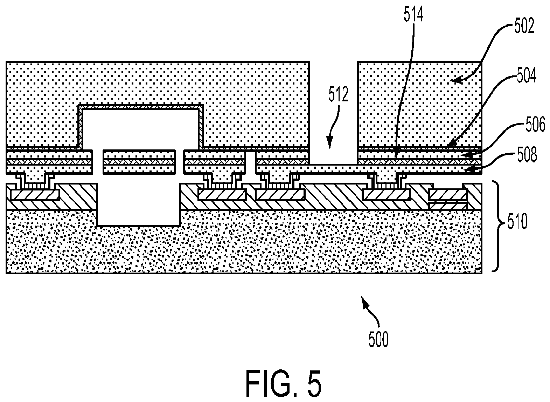

In one embodiment, the device wafer 106 comprises two layers of silicon, a top structural layer and a bottom structural layer, fusion bonded through a dielectric. Figure 5 illustrates a MEMS device 500 with a device wafer that comprises two layers of silicon in accordance with an embodiment. The MEMS device 500 includes a MEMS substrate that comprises a handle wafer 502, a top structural layer 506 of a device wafer bonded to the handle wafer 502 via a first dielectric layer 504, and a bottom structural layer 508 of the device wafer bonded to the top structural layer 506 of the device wafer via a second dielectric layer 514. The MEMS device 500 includes a CMOS wafer 510 coupled to the bottom structural layer 508 of the device wafer.

In Figure 5, an opening 512 is produced from the etching of handle wafer 502, dielectric layer 504, top structural layer 506, and second dielectric layer 514. This reveals bottom structural layer, 508Thus, a thickness of the remaining structural layer is defined by a thickness of the bottom structural layer 508 of the device wafer and not by an etch duration.

In one embodiment, an additional substrate with fluidic or gas channels is bonded to a top surface of the MEMS substrate to create a fluidic or gas interface to an exposed portion of the MEMS device. One of ordinary skill in the art readily recognizes that the additional substrate can be bonded to a variety of surfaces including but not limited to a top surface of the handle wafer of the MEMS substrate. In another embodiment, the opening in the handle wafer and oxide layers is created by non-etching means including but not limited to saw dicing, laser drilling, laser-assisted etching, and mechanical drilling.

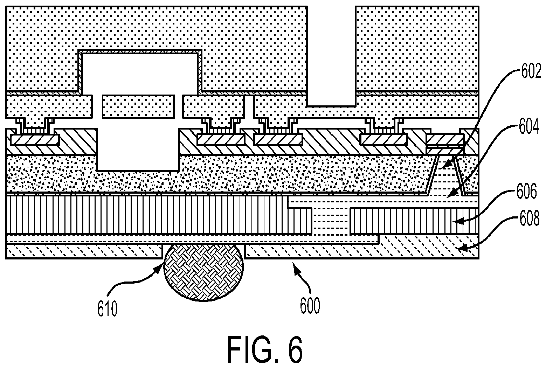

Figure 6 illustrates a wafer-level packaging process 600 of the MEMS device 100 in accordance with an embodiment. The MEMS device 100 has undergone the process described by Figures 2-4. The wafer-level packaging process 600 includes a Through-Silicon-Via (TSV) 602 that makes contact with the CMOS wafer metal, a redistribution metallization 604, a stress-relief and electrical isolation layer 606, a solder mask 608, and a solder ball 610. In another embodiment, a wedge dicing technique in combination with insulating and conducting makes contact with the CMOS wafer metal.

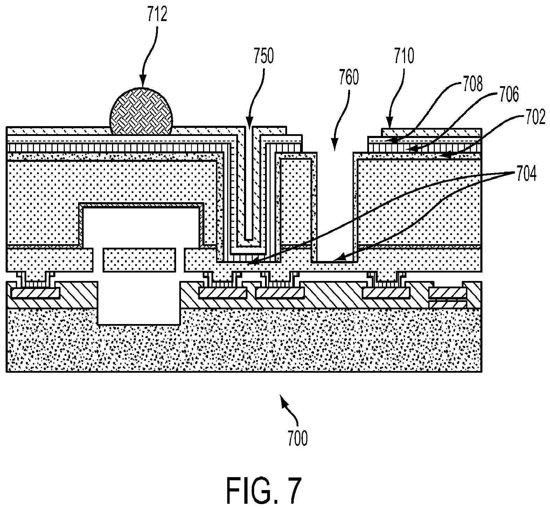

In one embodiment, the wafer-level packaging process is done using TSV from the MEMS substrate side which allows the process that etches the handle wafer to simultaneously create a port to expose the structural layer and define a via for the TSV contacts required for the wafer-level packaging process. In this embodiment, great care must be taken to protect the MEMS membrane layers from metallization and solder mask deposition. Figure 7 illustrates a wafer-level packaging process 700 of the MEMS device 100 in accordance with an embodiment. The MEMS device 100 has undergone the MEMS substrate side etch process described by Figures 2-4 and additionally, another timed membrane DRIE etch process that results in two openings 750 and 760 in the handle wafer 102.

The wafer-level packaging process 700 includes depositing a Silicon Dioxide (SiO2) insulator layer 702 using chemical vapor deposition (CVD) or a sputter method. The SiO2 insulator layer 702 is deposited over the entire top surface of the handle wafer 102 of the MEMS device 100 including each surface within the two openings that were previously etched. Only the bottom surfaces 704 of the two openings 750 and 760 that included the deposited SiO2 layer are etched. A first photoresist patterning is deposited in the opening 760 and then a redistribution layer (RDL) 706 is deposited using a lift-off process. An electroplating top metal 708 is deposited on top of the RDL 706. In one embodiment, the electroplating top metal 708 is Copper (Cu).

A second photoresist patterning is deposited in both the opening 760 and on a top surface on a left side of the handle wafer 702 and then an insulating solder mask layer 710 is deposited using a lift-off process. Finally, a solder ball 712 is deposited into the insulating solder mask layer 710 using screen/stencil printing. One of ordinary skill in the art readily recognizes that the solder ball 712 can be deposited by a variety of methodologies.

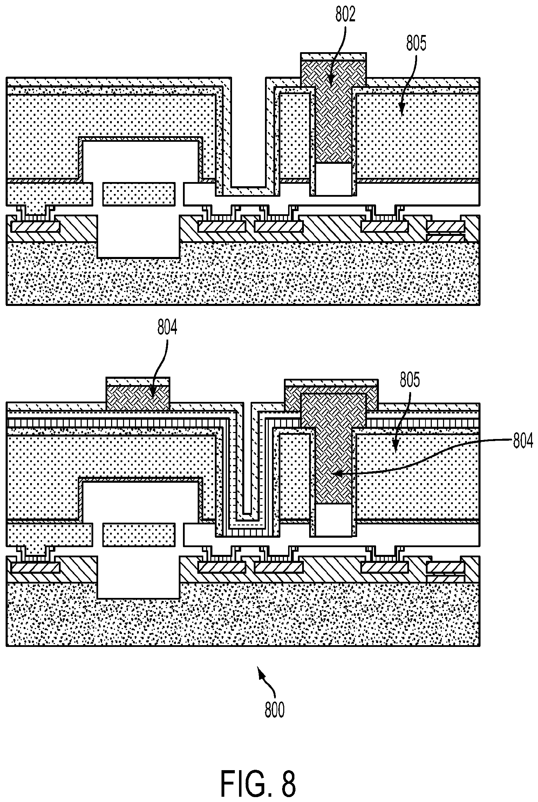

Figure 8 illustrates the photoresist patterning deposition 800 of Figure 7 in accordance with an embodiment. The photoresist patterning deposition 800 includes a first photoresist patterning 802 deposited in the opening 760 and a second photoresist 1304 in accordance with an embodiment. The standoff layer side-channel is sealed off by a eutectic bond during fabrication, but the standoff layer side-channel is opened to the outside environment during die singulation. One of ordinary skill in the art readily patterning 804 deposited in both the opening 760 and the top surface on the left side of the handle wafer 805.

A MEMS device can also be packaged in a plastic-molded package with a handle wafer that is combined with a mold cap that acts like a dam to prevent a mold compound from entering an opening/cavity in the handle wafer and contacting an exposed device layer. In one embodiment, the mold cap uses a soft material including but not limited to tape which enhances sealing of the opening/cavity in the handle wafer.

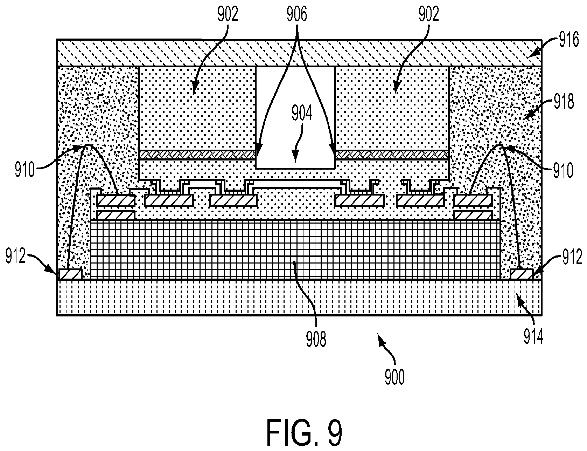

Figure 9 illustrates a plastic-molding packaging process 900 of a MEMS device as an example. The MEMS device includes a MEMS substrate comprising a handle wafer 902 and a device wafer 904 coupled to the handle wafer 902 via a dielectric layer 906. The MEMS substrate is bonded to a CMOS wafer 908. The CMOS wafer 908 is coupled to package pads 912 of a package lead frame 914 via wire bonding 910.

The plastic-molding packaging process 900 includes singulating die of the MEMS device and attaching the die to the package lead frame 914 via the wire bonding 910. The plastic-molding packaging process 900 includes coupling a mold cap 916 to a top surface of the handle wafer 902 of the MEMS device. Once a molding compound 918 is applied to the MEMS device, the mold cap 916 prevents the molding compound 918 from entering an opening of the handle wafer 902 and coming in contact with exposed device layers of the MEMS device. After the molding compound 918 application has completed, the mold cap 916 is removed and the MEMS device is singulated.

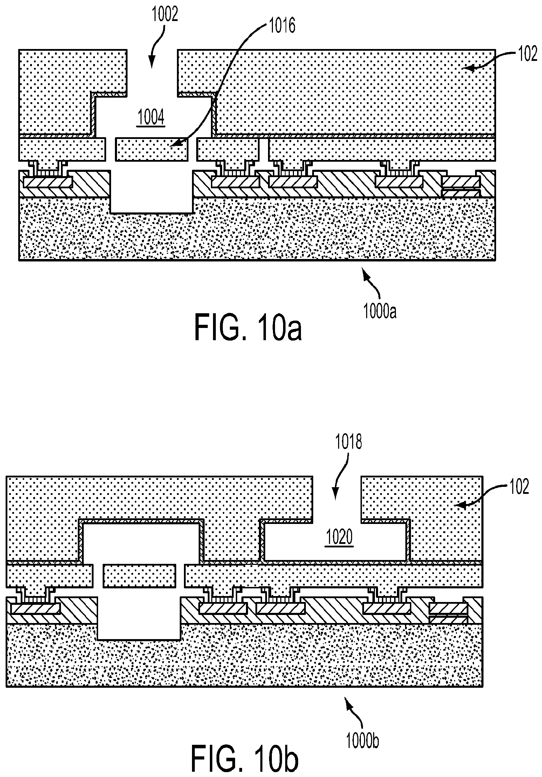

In one example, the etch process of the MEMS device is done on an area of the handle wafer that is located above the exposed device layers. Figure 10a illustrates a MEMS device 1000 in accordance with a further example. The MEMS device 1000a includes a MEMS substrate bonded to a CMOS substrate via at least one standoff. The handle wafer of the MEMS device 1000a has been etched in a region 1002 located above an upper cavity 1004 of the MEMS device 1000 that is exposed to the outside environment. There are three distinct benefits for an upper cavity, 1004. First, the termination of the etched region to the upper cavity allows a free structure 1016 to be exposed. This structure may be but is not limited to a torsional mirror or other light modulating structure. A second benefit shown in Figure 10b is the reduction of the etching depth of the handle wafer 102. The etched region 1018 is thinner than the full thickness of the handle wafer 102 which results in a faster cycle time and lower manufacturing cost. The third benefit of the upper cavity 1020 is that its lateral dimension is better controlled and its alignment to the membrane defined by the standoffs 110 more accurate than those of the etched region 1018. Both alignment and etch profile of upper cavity 1020 are superior to those of the etched region 1020 which is performed after CMOS-MEMS bonding. The improvement in the overlay of the upper cavity 1018 with respect to the standoffs 110 is expected to reduce any degradation of package sensitivity due to misalignment or imbalance.

In one variation, a section of a device wafer of the MEMS device is exposed to the outside environment by extending an upper cavity of the MEMS device to a dicing lane edge so that the upper cavity is exposed to the outside environment when the MEMS device is singulated, thus creating a side-channel exposed to the outside environment. One of ordinary skill in the art readily recognizes that this embodiment can be utilized in a variety of applications including but not limited to exposing a pressure-sensor flexible plate to outside environment pressure.

In this example, a cavity seal of the MEMS device is maintained during all pre-singulation wafer processing preventing the need to protect the openings in the handle wafer/MEMS device from process liquids, gasses, and residues. In another embodiment, the side-channel remains sealed by a variety of mechanisms including but not limited to a narrow side plate and a fusion bond after singulation to protect the side-channel from singulation residues. The narrow side plate or fusion bond is then opened at a later stage through a puncturing process including but not limited to laser machining and laser dicing.

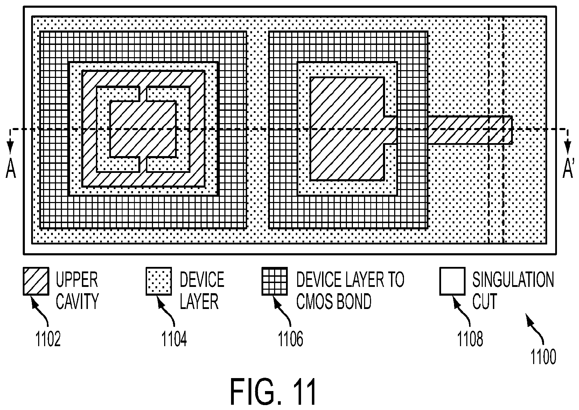

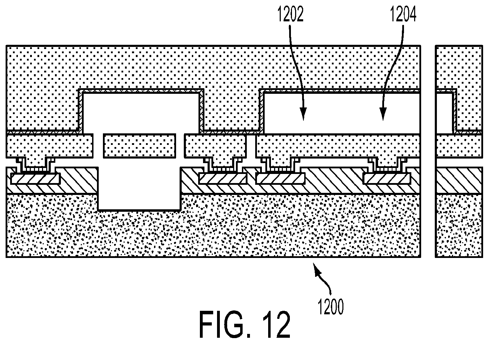

Figure 11 illustrates a top view 1100 of a cavity of a MEMS device as a further example. The cavity of the MEMS device is exposed to an outside environment. The MEMS device 1100 includes an upper cavity 1102, a device layer 1104, a bond 1106 between the device layer 1104 and a CMOS wafer, and a singulation cut 1108. Figure 12 illustrates a cross-section view A-A' 1200 of the MEMS device of Figure 11. The MEMS device 1200 includes an upper cavity 1202 that has been extended to a dicing lane edge and a side-channel 1204 that is connected to a portion of the device wafer that is exposed to the outside environment.

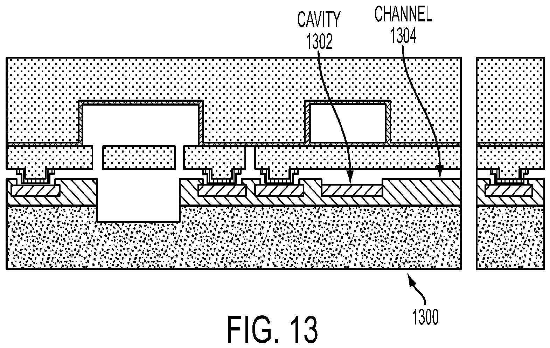

Figure 13 illustrates a cross-section view A-A' 1300 of a MEMS device with a cavity 1302 exposed to the outside environment through a standoff layer side-channel recognizes that singulation can be accomplished in a variety of ways including but not limited to using a dicing saw or a dry process such as stealth dicing and laser dicing to avoid residue.

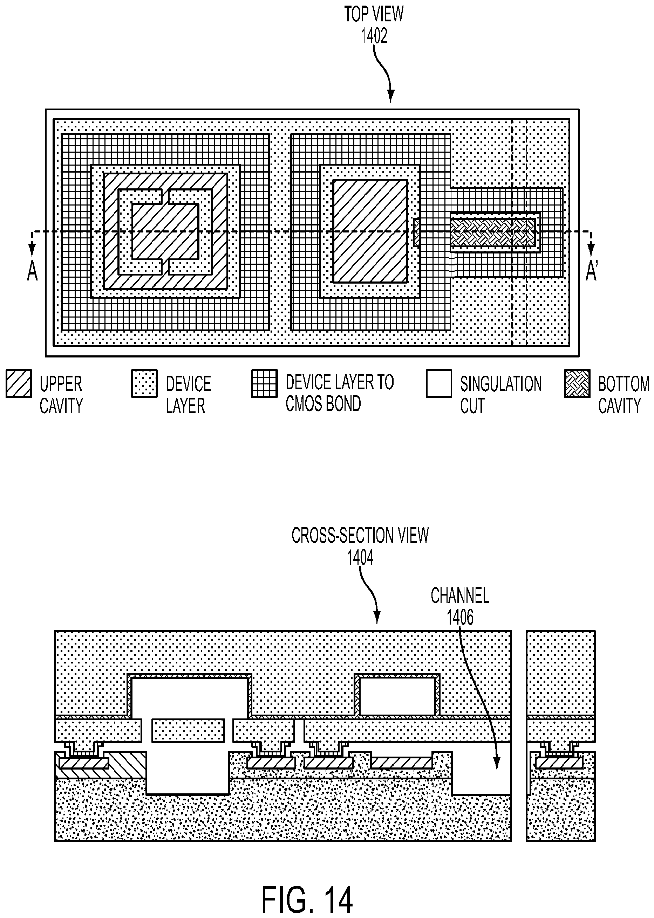

Figure 14 illustrates a top view 1402 and a cross-section view 1404 of a MEMS device with a side-channel 1406 as a further example. In this example a cavity of a MEMS device exposed to the outside environment through a side-channel is achieved using a bottom cavity in the CMOS wafer. The side-channel is sealed off by a eutectic bond during fabrication, but the side-channel is opened to the outside environment during die singulation.

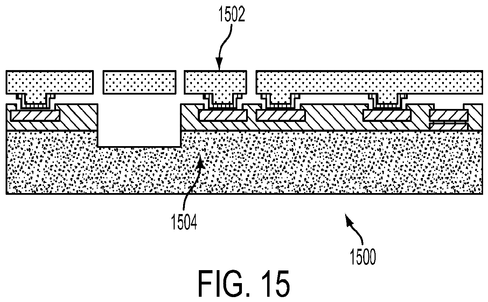

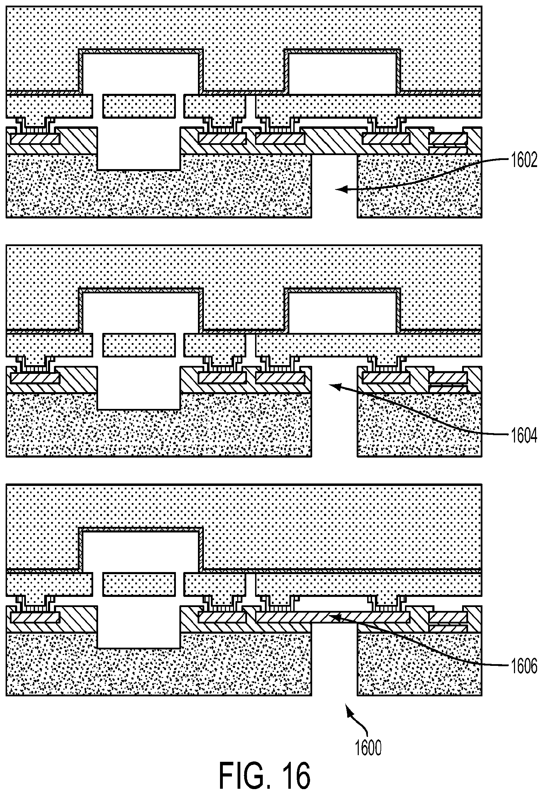

Figure 15 illustrates a MEMS device 1500 as a further example. In this example the handle wafer of the MEMS device 1500 is completely removed by etching or grinding or a combination of both. The MEMS device 1500 includes a MEMS wafer 1502 and a base wafer 1504 coupled to the MEMS wafer 1502. The MEMS wafer 1502 does not include a handle wafer portion. Figure 16 illustrates a fabrication process 1600 of a MEMS device to create a CMOS wafer opening as a further illustrative example. The fabrication process 1600 includes etching (using wet or dry chemical etching) an opening in a CMOS wafer substrate silicon of the MEMS device, via step 1602. The fabrication process 1600 then either includes etching entirely through CMOS inter-metal dielectric and passivation layers to expose a MEMS portion of the MEMS device to the outside environment, via step 1604, or includes partially exposing a metal membrane compound of one or more CMOS metals and dielectric layers, via step 1606. The etching produces a through hole in the CMOS thereby exposing a MEMS feature. In step 1606, the MEMS device layer is used as a stationary electrode to capacitively sense motion of the metal membrane.

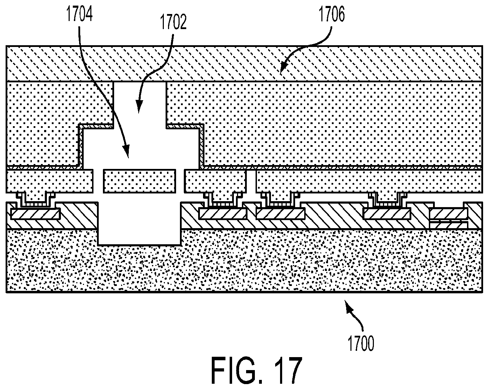

Figure 17 illustrates a MEMS device 1700 as a further example. The MEMS device 1700 resembles the MEMS device 1000 of Figure 10. Thus, the MEMS device 1700 includes an opening 1702 etched over and connected to an upper cavity 1704 of the MEMS device 1700. In Figure 17, a transparent plate 1706 is bonded to a top surface of a MEMS substrate portion of the MEMS device 1700 to allow a coupling and interaction with optical signals. In one embodiment, the transparent plate 1706 is a wafer that is transparent to certain wavelengths of light. The transparent plate 1706 also protects the MEMS substrate portion from environmental gases, moisture, and particles.

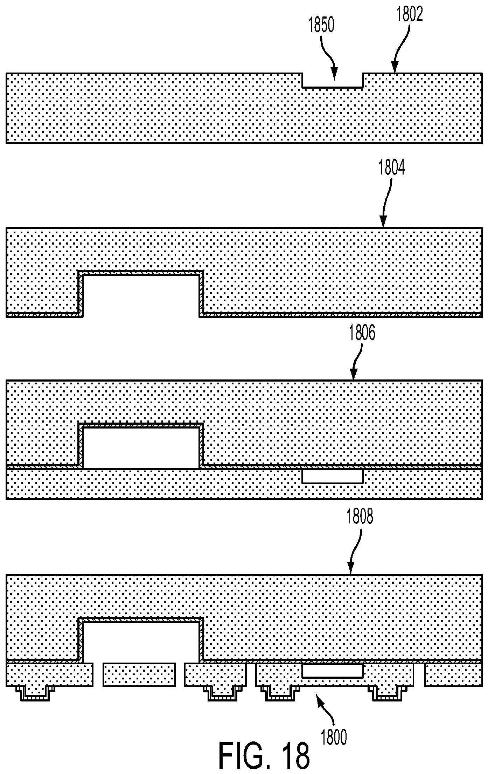

The device layer or substrate of the aforementioned MEMS devices is thinned during the aforementioned fabrication processes. In one embodiment, a portion of the device wafer to be exposed to the outside environment is thinned prior to fusion bonding to the handle wafer. Figure 18 illustrates a fabrication process 1800 of thinning a portion of a device wafer prior to fusion bonding to a handle wafer of a MEMS device in accordance preliminary method steps of an embodiment of the invention. The fabrication process 1800 includes forming a recess 1850 in a portion of the device wafer to produce a reduced thickness region via step 1802 and forming a cavity in the handle wafer via step 1804. An oxide is deposited onto the cavity side of the handle wafer and the handle wafer is fusion bonded to the device wafer such that the recess of the device wafer is facing towards the handle wafer, via step 1806. In step 1806, a device layer of a MEMS device comprising a device wafer fusion bonded to a handle wafer is thinned by grinding and polishing of the device wafer to a desired thickness.

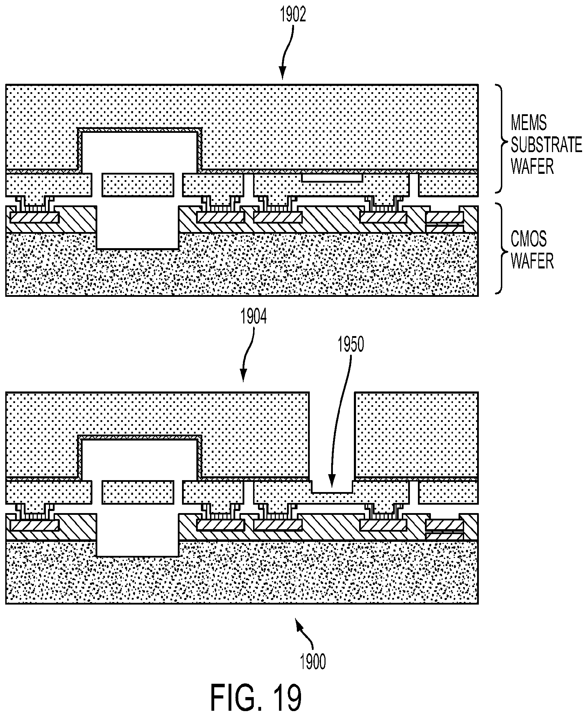

The fabrication process 1800 includes further processing and thinning of the device layer/MEMS substrate wafer by forming a plurality of standoffs on the device wafer, depositing Germanium or another material, and patterning and etching the device layer, via step 1808. Figure 19 illustrates a fabrication process 1900 of a MEMS device that has been processed according to the fabrication process 1800 in accordance with an embodiment of the invention. The resulting MEMS substrate wafer is bonded to a CMOS wafer, via step 1902 and then the recessed portion of the device layer 1950 is exposed to the outside environment by utilizing any of the aforementioned techniques, via step 1904.

In one embodiment, port openings in the aforementioned MEMS devices that are exposed to the outside environment are fully or partially filled with a porous material including but not limited to Gortex to allow gasses or liquids to still penetrate to the MEMS portion while protecting the MEMS device from larger particles and objects.

As above described, the method and system allow for the fabrication of more efficient and more accurate force sensing and force exerting MEMS devices. By coupling an integrated circuit substrate to a MEMS substrate and utilizing an open handle wafer cavity, a top surface of the MEMS substrate structural layer is exposed to the outside environment. On one side of a flexible plate of the MEMS substrate is a hermetically sealed cavity/chamber while the other side is exposed to the surrounding ambient environment.

The approach disclosed in accordance with an embodiment allows wafer-level integration of environment-exposed MEMS structures with CMOS wafers and also allows the integration of such structures with other non-exposed structures on a same die that has varying levels of thickness. Specifically, the structural layer thickness of the exposed device on the die may be different (e.g. thinner) than that of the structural layer thickness of the other devices on the die. This enables the exposed device to benefit from increased sensitivities. Additionally, the method and system provide wafer-level packaging of these MEMS devices without damaging or compromising the exposed structural layer.

Although the present invention has been described in accordance with the embodiments shown, one of ordinary skill in the art will readily recognize that there could be variations to the embodiments. Accordingly, many modifications may be made by one of ordinary skill in the art without departing from the spirit and scope of the appended claims.

## Claims

1. A method for providing a Microelectromechanical Systems (MEMS) device (400a) with a portion exposed to an outside environment, the method comprising:
bonding a handle wafer (102) to a device wafer (106) to form a MEMS substrate, wherein a dielectric layer (104) is disposed between the handle and device wafers;
lithographically defining at least one standoff (110) on the device wafer;
bonding the at least one standoff to an integrated circuit substrate to form a sealed cavity between the MEMS substrate and the integrated circuit substrate;
etching at least one opening in the handle wafer to expose a portion of the dielectric layer;
etching the exposed portion of the dielectric layer to expose a portion of the device wafer to the outside environment; and
partially etching the exposed portion of the device wafer to reduce thickness of the device wafer.

2. The method of claim 1, wherein the integrated circuit substrate comprises a CMOS wafer (108) with at least one electrode and at least one circuit coupled to the at least one electrode.

3. The method of claim 1, wherein a gap of the sealed cavity is defined by a height of the at least one standoff (110).

4. The method of claim 1, further comprising:
creating an electrical connection between the device wafer (106) and the integrated circuit substrate by utilizing a conductive bond between the at least one standoff (110) and the integrated circuit substrate.

5. The method of claim 1, wherein the exposed portion of the device wafer (106) is a flexible plate, wherein at least one region of the flexible plate is a surface of the sealed cavity.

6. The method of claim 1, further comprising:
bonding a substrate with fluidic channels to a top surface of the MEMS substrate (400a).

7. The method of claim 1, further comprising:
packaging the MEMS device (400a) using a Through-Silicon-Via process.

8. The method of claim 1, further comprising:
packaging the MEMS device (400a) in a plastic molded package using the handle wafer (102) as a dam to prevent a molding compound from entering a membrane area of the sealed cavity.

9. The method of claim 1, further comprising:
packaging the MEMS device (400a) in a plastic molded package using adhesion tape to prevent a molding compound from entering a membrane area of the sealed cavity.

10. The method of claim 1, wherein etching the at least one opening in the handle wafer (102) further produces sloped sidewalls.

11. A Microelectromechanical Systems (MEMS) device (400a) with a portion exposed to an outside environment comprising:
a CMOS substrate (108);
a MEMS substrate bonded to the CMOS substrate, wherein the MEMS substrate includes a handle substrate (102) bonded to a device substrate (106) with a dielectric layer (104) disposed between the handle and device substrates; and
at least one opening in the handle substrate, the dielectric layer and partially in the device substrate, wherein the at least one opening exposes a portion of the device substrate to the outside environment,
wherein a sealed cavity is formed between the MEMS substrate and the CMOS substrate and is defined by a height of at least one standoff (110) lithographically defined on the device substrate.

12. The MEMS device (400a) of claim 11, wherein the at least one opening is a fluidic channel that allows fluid flow.

13. The MEMS device (400a) of claim 11, wherein the at least one opening is located over the sealed cavity.

14. The MEMS device (400a) of claim 11, wherein the device substrate (106) further comprises:
a top structural layer (506) bonded to a bottom structural layer (508) with a second dielectric layer (514) disposed between the top and bottom structural layers, wherein the top structural layer is disposed between the dielectric layer (104) and the second dielectric layer.

15. The MEMS device (400a) of claim 14, wherein the at least one opening extends through the dielectric layer (104) and the top structural layer (506) to expose a region of the second dielectric layer (514) to the outside environment.

16. The MEMS device (400a) of claim 11, comprising at least one cavity in the handle substrate (102) wherein the at least one opening in the handle substrate extends into the at least one cavity in the handle substrate.

17. The MEMS device (400a) of claim 11, wherein the at least one opening extends to the edge of the device.

## Patentansprüche

1. Verfahren zur Bereitstellung einer Mikroelektromechaniksystem- (MEMS-) Vorrichtung (400a) mit einem Abschnitt, der einer äußeren Umgebung ausgesetzt ist, das Verfahren umfassend:
Verbinden eines Handhabungswafers (102) mit einem Vorrichtungswafer (106), um ein MEMS-Substrat zu bilden, wobei eine dielektrische Schicht (104) zwischen dem Handhabungs- und dem Vorrichtungswafer angeordnet wird;
Lithografisches Definieren mindestens eines Abstandshalters (110) auf dem Vorrichtungswafer;
Verbinden des mindestens einen Abstandshalters mit einem Substrat einer integrierten Schaltung, um einen versiegelten Hohlraum zwischen dem MEMS-Substrat und dem Substrat der integrierten Schaltung zu bilden;
Ätzen mindestens einer Öffnung in den Handhabungswafer, um einen Abschnitt der dielektrischen Schicht freizulegen;
Ätzen des freigelegten Abschnitts der dielektrischen Schicht, um einen Abschnitt des Vorrichtungswafers der äußeren Umgebung auszusetzen; und
teilweises Ätzen des freigelegten Abschnitts des Vorrichtungswafers, um eine Dicke des Vorrichtungswafers zu verringern.

2. Verfahren nach Anspruch 1, wobei das Substrat der integrierten Schaltung einen CMOS-Wafer (108) mit mindestens einer Elektrode und mindestens einer Schaltung, die mit der mindestens einen Elektrode gekoppelt ist, umfasst.

3. Verfahren nach Anspruch 1, wobei ein Zwischenraum des versiegelten Hohlraums von einer Höhe des mindestens einen Abstandshalters (110) definiert wird.

4. Verfahren nach Anspruch 1, ferner umfassend:
Schaffen einer elektrischen Verbindung zwischen dem Vorrichtungswafer (106) und dem Substrat der integrierten Schaltung durch Nutzung einer leitenden Verbindung zwischen dem mindestens einen Abstandshalter (110) und dem Substrat der integrierten Schaltung.

5. Verfahren nach Anspruch 1, wobei der freigelegte Abschnitt des Vorrichtungswafers (106) eine flexible Platte ist, wobei mindestens ein Bereich der flexiblen Platte eine Fläche des versiegelten Hohlraums ist.

6. Verfahren nach Anspruch 1, ferner umfassend:
Verbinden eines Substrats mit Fluidkanälen mit einer Oberseite des MEMS-Substrats (400a).

7. Verfahren nach Anspruch 1, ferner umfassend:
Verpacken der MEMS-Vorrichtung (400a) mithilfe eines Silizium-Durchkontaktierungs-Prozesses.

8. Verfahren nach Anspruch 1, ferner umfassend:
Verpacken der MEMS-Vorrichtung (400a) in einer kunststoffgeformten Verpackung mithilfe des Handhabungswafers (102) als Damm, um zu verhindern, dass ein Formungsverbundstoff in einen Membranbereich des versiegelten Hohlraums eindringt.

9. Verfahren nach Anspruch 1, ferner umfassend:
Verpacken der MEMS-Vorrichtung (400a) in einer kunststoffgeformten Verpackung mithilfe von Klebeband, um zu verhindern, dass ein Formungsverbundstoff in einen Membranbereich des versiegelten Hohlraums eindringt.

10. Verfahren nach Anspruch 1, wobei Ätzen der mindestens einen Öffnung in dem Handhabungswafer (102) ferner geneigte Seitenwände erzeugt.

11. Mikroelektromechaniksystem- (MEMS-) Vorrichtung (400a) mit einem Abschnitt, der einer äußeren Umgebung ausgesetzt ist, umfassend:
ein CMOS-Substrat (108);
ein MEMS-Substrat, das mit dem CMOS-Substrat verbunden ist, wobei das MEMS-Substrat ein Handhabungssubstrat (102) enthält, das mit einem Vorrichtungssubstrat (106) mit einer dielektrischen Schicht (104) verbunden ist, die zwischen dem Handhabungs- und dem Vorrichtungssubstrat angeordnet ist; und
mindestens eine Öffnung in dem Handhabungssubstrat, der dielektrischen Schicht und teilweise in dem Vorrichtungssubstrat, wobei die mindestens eine Öffnung einen Abschnitt des Vorrichtungssubstrats der äußeren Umgebung aussetzt,
wobei ein versiegelter Hohlraum zwischen dem MEMS-Substrat und dem CMOS-Substrat ausgebildet und von einer Höhe mindestens eines Abstandshalters (110) definiert ist, der lithographisch auf dem Vorrichtungssubstrat definiert ist.

12. MEMS-Vorrichtung (400a) nach Anspruch 11, wobei die mindestens eine Öffnung ein Fluidkanal ist, der einen Fluidstrom erlaubt.

13. MEMS-Vorrichtung (400a) nach Anspruch 11, wobei sich die mindestens eine Öffnung über dem versiegelten Hohlraum befindet.

14. MEMS-Vorrichtung (400a) nach Anspruch 11, wobei das Vorrichtungssubstrat (106) ferner Folgendes umfasst:
eine obere strukturelle Schicht (506), die mit einer unteren strukturellen Schicht (508) verbunden ist, wobei eine zweite dielektrische Schicht (514) zwischen der oberen und der unteren strukturellen Schicht angeordnet ist, wobei die obere strukturelle Schicht zwischen der dielektrischen Schicht (104) und der zweiten dielektrischen Schicht angeordnet ist.

15. MEMS-Vorrichtung (400a) nach Anspruch 14, wobei sich die mindestens eine Öffnung durch die dielektrische Schicht (104) und die obere strukturelle Schicht (506) erstreckt, um einen Bereich der zweiten dielektrischen Schicht (514) der äußeren Umgebung auszusetzen.

16. MEMS-Vorrichtung (400a) nach Anspruch 11, umfassend mindestens einen Hohlraum in dem Handhabungssubstrat (102), wobei sich die mindestens eine Öffnung in dem Handhabungssubstrat in den mindestens einen Hohlraum in dem Handhabungssubstrat erstreckt.

17. MEMS-Vorrichtung (400a) nach Anspruch 11, wobei sich die mindestens eine Öffnung zu dem Rand der Vorrichtung erstreckt.

## Revendications

1. Procédé destiné à obtenir un dispositif (400a) à systèmes microélectromécaniques (MEMS) avec une partie exposée à un environnement extérieur, le procédé comprenant :
l'assemblage d'une tranche de support (102) à une tranche de dispositif (106) pour former un substrat MEMS, une couche diélectrique (104) étant disposée entre les tranches de support et de dispositif ;
la définition par lithographie d'au moins une entretoise (110) sur la tranche de dispositif ;
l'assemblage de l'au moins une entretoise à un substrat de circuit intégré pour former une cavité scellée entre le substrat MEMS et le substrat de circuit intégré ;
la gravure d'au moins une ouverture dans la tranche de support pour exposer une partie de la couche diélectrique ;
la gravure de la partie exposée de la couche diélectrique pour exposer une partie de la tranche de dispositif à l'environnement extérieur ; et
la gravure partielle de la partie exposée de la tranche de dispositif pour réduire l'épaisseur de la tranche de dispositif.

2. Procédé de la revendication 1, dans lequel le substrat de circuit intégré comprend une tranche CMOS (108) avec au moins une électrode et au moins un circuit couplé à l'au moins une électrode.

3. Procédé de la revendication 1, dans lequel un espace de la cavité scellée est défini par une hauteur de l'au moins une entretoise (110).

4. Procédé de la revendication 1, comprenant en outre :
la création d'une connexion électrique entre la tranche de dispositif (106) et le substrat de circuit intégré au moyen d'une jonction conductrice entre l'au moins une entretoise (110) et le substrat de circuit intégré.

5. Procédé de la revendication 1, dans lequel la partie exposée de la tranche de dispositif (106) est une plaque flexible, au moins une région de la plaque flexible étant une surface de la cavité scellée.

6. Procédé de la revendication 1, comprenant en outre :
l'assemblage d'un substrat avec des canaux fluidiques à une surface supérieure du substrat MEMS (400a).

7. Procédé de la revendication 1, comprenant en outre :
la mise en boîtier du dispositif MEMS (400a) au moyen d'un procédé de trou d'interconnexion à travers le silicium.

8. Procédé de la revendication 1, comprenant en outre :
la mise en boîtier du dispositif MEMS (400a) dans un boîtier en plastique moulé en utilisant la tranche de support (102) comme un barrage pour empêcher un composé de moulage d'entrer dans une zone de membrane de la cavité scellée.

9. Procédé de la revendication 1, comprenant en outre :
la mise en boîtier du dispositif MEMS (400a) dans un boîtier en plastique moulé en utilisant un ruban adhésif pour empêcher un composé de moulage d'entrer dans une zone de membrane de la cavité scellée.

10. Procédé de la revendication 1, dans lequel la gravure de l'au moins une ouverture dans la tranche de support (102) produit en outre des parois latérales inclinées.

11. Dispositif (400a) à systèmes microélectromécaniques (MEMS) avec une partie exposée à un environnement extérieur comprenant :
un substrat CMOS (108) ;
un substrat MEMS assemblé au substrat CMOS, le substrat MEMS comportant un substrat de support (102) assemblé à un substrat de dispositif (106) avec une couche diélectrique (104) disposée entre les substrats de support et de dispositif ; et
au moins une ouverture dans le substrat de support, la couche diélectrique et partiellement dans le substrat de dispositif, l'au moins une ouverture exposant une partie du substrat de dispositif à l'environnement extérieur,
dans lequel une cavité scellée est formée entre le substrat MEMS et le substrat CMOS et est définie par une hauteur d'au moins une entretoise (110) définie par lithographie sur le substrat de dispositif.

12. Dispositif MEMS (400a) de la revendication 11, dans lequel l'au moins une ouverture est un canal fluidique qui permet un écoulement de fluide.

13. Dispositif MEMS (400a) de la revendication 11, dans lequel l'au moins une ouverture est située par-dessus la cavité scellée.

14. Dispositif MEMS (400a) de la revendication 11, dans lequel le substrat de dispositif (106) comprend en outre :
une couche de structure supérieure (506) assemblée à une couche de structure inférieure (508) avec une deuxième couche diélectrique (514) disposée entre les couches de structure supérieure et inférieure, la couche de structure supérieure étant disposée entre la couche diélectrique (104) et la deuxième couche diélectrique.

15. Dispositif MEMS (400a) de la revendication 14, dans lequel l'au moins une ouverture s'étend à travers la couche diélectrique (104) et la couche de structure supérieure (506) pour exposer une région de la deuxième couche diélectrique (514) à l'environnement extérieur.

16. Dispositif MEMS (400a) de la revendication 11, comprenant au moins une cavité dans le substrat de support (102), l'au moins une ouverture dans le substrat de support s'étendant à l'intérieur de l'au moins une cavité dans le substrat de support.

17. Dispositif MEMS (400a) de la revendication 11, dans lequel l'au moins une ouverture s'étend jusqu'au bord du dispositif.
